(19) **Europäisches Patentamt**

**European Patent Office**

**Office européen des brevets**

(11) **EP 0 992 180 B1**

(12) **EUROPÄISCHE PATENTSCHRIFT**

(45) Veröffentlichungstag und Bekanntmachung des Hinweises auf die Patenterteilung:
**22.05.2002 Patentblatt 2002/21**

(21) Anmeldenummer: **98936128.2**

(22) Anmeldetag: **10.06.1998**

(51) Int Cl.⁷: **H05B 43/00**

(86) Internationale Anmeldenummer:
**PCT/DE98/01581**

(87) Internationale Veröffentlichungsnummer:
**WO 99/01014 (07.01.1999 Gazette 1999/01)**

(54) **VERFAHREN ZUR AUTOMATISCHEN INTENSITÄTSEINSTELLUNG EINER BELEUCHTUNG FÜR EINRICHTUNGEN ZUR LAGEERKENNUNG UND/ODER QUALITÄTSKONTROLLE**

METHOD FOR AUTOMATICALLY CONTROLLING THE INTENSITY OF A LIGHTING USED IN UNITS FOR DETECTING A POSITION AND/OR FOR QUALITY CONTROL

PROCEDE POUR REGLER AUTOMATIQUEMENT L'INTENSITE D'UN ECLAIRAGE DESTINE A DES UNITES SERVANT A DETECTER UNE POSITION ET/OU A EFFECTUER UN CONTROLE DE QUALITE

(84) Benannte Vertragsstaaten:
**CH DE FR GB IT LI NL**

(30) Priorität: **27.06.1997 DE 19727471**

(43) Veröffentlichungstag der Anmeldung:
**12.04.2000 Patentblatt 2000/15**

(73) Patentinhaber: **SIEMENS AKTIENGESELLSCHAFT 80333 München (DE)**

(72) Erfinder:
- **WITTMANN, Günther D-80796 München (DE)**
- **HEDRICH, Matthias D-81475 München (DE)**

(56) Entgegenhaltungen:
**US-A- 5 185 811**

- **PATENT ABSTRACTS OF JAPAN vol. 017, no. 522 (P-1616), 20.September 1993 & JP 05 141921 A (MATSUSHITA ELECTRIC IND CO LTD), 8.Juni 1993,**
- **PATENT ABSTRACTS OF JAPAN vol. 096, no. 011, 29.November 1996 & JP 08 189901 A (FUJI ELECTRIC CO LTD;FUJI FACOM CORP), 23.Juli 1996,**
- **PATENT ABSTRACTS OF JAPAN vol. 096, no. 010, 31.Oktober 1996 & JP 08 152311 A (TOYOTA CENTRAL RES &AMP;DEV LAB INC; TOYOTA MOTOR CORP), 11.Juni 1996, in der Anmeldung erwähnt**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren zur automatischen Intensitätseinstellung der Beleuchtung bei Einrichtungen zur Lageerkennung und/oder Qualitätskontrolle für die automatische Bestückung von Bauelementen nach dem Oberbegriff des Patentanspruches 1.

Bei der automatischen Bestückung von Leiterplatten oder Keramiksubstraten mit Bauelementen, insbesondere SMD-Bauelementen, wird vor dem Bestücken die Lage der Bauelemente relativ zur Aufsetzposition auf der Leiterplatte mittels Einrichtungen zur Lageerkennung bestimmt. Unter dem Begriff Bauelemente werden im folgenden alle bestückfähigen Gegenstände erfaßt, beispielsweise auch Abschirmbleche. Als Lageerkennungseinrichtungen werden im allgemeinen Visionsysteme eingesetzt, die eine Kamera, beispielsweise eine CCD-Kamera, und eine Beleuchtungseinrichtung umfassen. Eine visuelle Inspektion der Bauelemente erfolgt in analog aufgebauten Einrichtungen zur Qualitätskontrolle. Die Beleuchtung ist dabei so zu wählen, daß Nutzstrukturen ( im allgemeinen die Anschlüsse der Bauelemente) sehr kontrastreich dargestellt werden, während Störstrukturen (beispielsweise der Körper der Bauelemente) unterdrückt werden.

Für diesen Zweck sind Verfahren bekannt, bei denen mit Hilfe von Beleuchtungseinrichtungen, die in mehrere Lichtquellen mit jeweils separat regelbarer Intensitätssteuerung unterteilt sind, die Bauelemente aus unterschiedlichen Winkel mit unterschiedlichen Intensitäten beleuchtet werden.

Aus JP 8-152311 (A) ist beispielsweise die Beleuchtung von Lötverbindungen aus unterschiedlichen Richtungen bekannt, um die Qualität der Lötverbindungen zu untersuchen. Die bei den einzelnen Beleuchtungen ermittelten Grauwerte werden in einer Bildauswerteeinheit aufsummiert. Es ist allerdings kein Hinweis entnehmbar, wie eine solche Beleuchtung automatisch einstellbar zu realisieren ist.

Aus WO 96/21343 ist beispielsweise ein Verfahren bekannt, bei dem mit Hilfe einer segmentierten Ringbeleuchtung die Bauelemente nicht aus allen Winkeln gleichmäßig beleuchtet werden, sondern aus bestimmten Winkeln kein Licht auf die Struktur fällt. Damit werden Abbildungen von unter diesen bestimmten Winkeln besonders auffällig hervortretenden Störstrukturen unterdrückt.

Nachteilig bei den bekannten Verfahren mit mehreren Lichtquellen ist die Tatsache, daß für jedes neue Bauelement zunächst durch einen Bediener eine optimale Beleuchtung für dieses Bauelement manuell eingestellt werden muß. Dazu sind die Intensitäten der einzelnen Lichtquellen durch den Bediener zu regeln, bis er durch eine visuelle Kontrolle eine für die Lageerkennung oder Qualitätskontrolle ausreichende Beleuchtung erzielt hat. Die Intensitätseinstellung wird dabei bedienerspezifisch und nicht reproduzierbar sein, wie es für eine Bestückung mit hohen Stückzahlen erforderlich wäre.

Aus US 54 54 049 ist ein Verfahren zur automatischen Beleuchtungseinstellung für eine Lichtquelle bekannt, bei dem mit einer Kamera aufgenommene und in einer Bildauswerteeinheit gespeicherte Grauwerte dahingehend durch eine Intensitätssteuereinrichtung verändert werden, daß der vorhandene Grauwertbereich der Bildauswerteeinheit möglichst gut ausgenutzt wird. Für die Beleuchtung mit mehreren Lichtquellen ist dieses Verfahren nicht geeignet, da der Einfluß der Intensitäten der einzelnen Lichtquellen nicht berücksichtigt wird.

Aufgabe der Erfindung ist es, ein reproduzierbares, automatisches Verfahren zu entwickeln, mit dem die Intensitätseinstellung der Beleuchtung bei einer mindestens zwei Lichtquellen umfassenden Beleuchtungseinrichtung für die Lageerkennung und Qualitätskontrolle beim Bestücken von Bauelementen gewährleistet ist.

Die Aufgabe wird erfindungsgemäß mit einem Verfahren mit den kennzeichnenden Merkmalen des Patentanspruches 1 gelöst.

Gegenüber den bekannten Verfahren weist das erfindungsgemäße Verfahren den Vorteil auf, eine automatische Beleuchtungseinstellung zu erzielen, die bedienerunabhängig und automatisiert, das heißt ohne aufwendige, zeitintensive Versuche abläuft und damit eine einwandfreie Beleuchtung eines Bauelementes in den Einrichtungen zur Lageerkennung und/oder Qualitätskontrolle eines Bestückautomaten sicherstellt.

Anhand eines Ausführungsbeispiels und der einzigen Figur wird die Erfindung näher erläutert.

Dabei zeigt die Figur einen schematischen Querschnitt durch die Einrichtung zur Lageerkennung und/oder Qualitätskontrolle in einem Bestückautomaten.

In einem Bestückautomaten zur Bestückung einer Leiterplatte werden die von einer an einem Bestückkopf 1 befestigten Saugpipette 2 aus Vorratsbehältern aufgenommenen Bauelemente 3 in eine Lageerkennungseinrichtung auf ihre relative Lage an der Saugpipette 2 untersucht, indem die Bauelemente 3 durch eine Beleuchtungseinrichtung aus mehreren Lichtquellen 4 beleuchtet werden. Die Intensität jeder Lichtquelle 4 läßt sich separat durch eine zugeordnete Intensitätssteuereinrichtung 5 regeln. Das entstehende Bild des Bauelementes wird durch eine Kamera 6 und eine der Kamera 6 nachgeschaltete Bildauswerteeinheit 7 aufgenommen und abgespeichert. Im allgemeinen wird mit CCD-Kameras gearbeitet, deren kleinste Auflösung Pixel genannt wird. Jedem Pixel ist ein Grauwert zugeordnet, wobei ein höherer Grauwert einer größeren Helligkeit entspricht. Bei der Verwendung von Farbkameras werden Werte abgespeichert, die der detektierten Farbe entsprechen. Diese Werte werden im weiteren ebenfalls mit dem Begriff Grauwert bezeichnet, da sich das erfindungsgemäße Verfahren in gleicher Weise auch für Farbkameras eignet. Durch Vergleich der aufgenommenen Lage der Anschlüsse 9 bzw. der Nutzstrukturen 9 der Bauelemente 3 mit abgespeicherten Vergleichsmustern ist die Bildauswerteinheit 7 in der Lage, die aktuelle Position des Bauelementes 3 an der Saugpipette 2 zu erkennen, eine Korrektur auszurechnen und die Korrektur an eine zentrale Steuereinheit des Bestückautomaten weiterzuleiten, damit anschließend die Position der Saugpipette 2 oder der Leiterplatte so variiert wird , daß das Bauelement 3 richtig positioniert auf die Leiterplatte aufgesetzt wird.

Zum Bestimmen einer eindeutigen Relation zwischen Vergleichsmustern und aufgenommenen Bild des Bauelementes 3 sind kontrastreich abgebildete Nutzstrukturen 9 (beispielsweise Anschlüsse) bei gleichzeitiger Unterdrückung von Störstrukturen 8 (beispielsweise der Körper des Bauelementes 3) erforderlich, was durch die Intensitätseinstellung der Beleuchtung erzielt wird.

Das erfindungsgemäße Verfahren erreicht eine optimale, automatische Beleuchtungseinstellung in der Einrichtung zur Lageerkennung und/oder Qualitätskontrolle dadurch, daß zunächst anhand eines Exemplars der zu bestückenden Bauelemente 3 eine Zuordnung der Pixel der Kamera 6 zu Nutz- und Störstrukturen 9,8 des Bauelementes 3 erfolgt. Die Zuordnung erfolgt dabei beispielsweise durch eine theoretische Beschreibung der geometrischen Struktur des Bauelementes 3, die in die Bildauswerteinheit 7 eingespeichert wird. Eine weitere Möglichkeit ist die Darstellung des aufgenommenen Bildes des Bauelementes 3 auf einem an die Bildauswerteinheit 7 angeschlossenen Bildschirm (nicht dargestellt), auf dem ein Bediener visuell Nutz- und Störstrukturen 9,8 identifizieren kann. Die Zuordnung erfolgt dann manuell durch den Bediener, in dem er die jeweils zugeordneten Bereiche auf dem Bildschirm kennzeichnet, die dann in der Bildauswerteinheit 7 eingespeichert werden.

Diese Möglichkeit bietet den Vorteil, daß eine zum Verfahren zugehörige manuelle Justage des Bauelementes 3 in der Lageerkennungseinrichtung im Verlauf der visuellen Identifikation von Stör- und Nutzstrukturen 8,9 erfolgen kann.

Eine Beschleunigung des Verfahrens läßt sich erreichen, in dem die Auflösung durch Zusammenfassen von mehreren Pixeln zu sogenannten Moxeln reduziert wird. Den Moxeln wird dabei durch Mittelung der den Pixeln zugeordneten Grauwerte ein gemittelter Grauwert zugeordnet.

Für das weitere Verfahren werden im folgenden ermittelt:

a) der maximale Grauwert $N_{max}$ der Nutzstrukturen 9,
b) der Mittelwert N der Grauwerte der Nutzstrukturen 9,
c) der minimale Grauwert $N_{min}$ der Nutzstrukturen 9,
d) der maximale Grauwert $S_{max}$ der Störstrukturen 8 ,
e) der Mittelwert S der Grauwerte der Störstrukturen 8.

Bei Beleuchtung mit einer Anzahl i Lichtquellen 4 mit jeweiliger Intensität $x_i$ ergeben sich die Grauwerte als Summe aus Grauwertanteilen, die bei Beleuchtung mit nur einer Lichtquelle 4 ermittelt werden. Unter der Annahme, daß Sättigungseffekte in der Kamera vernachlässigt werden können, ergeben sich lineare Abhängigkeiten zwischen den Intensitäten $x_i$ der einzelnen Lichtquellen 4 und den Grauwertanteilen, die durch entsprechende Koeffizienten

$a_{n,max,i}$ für maximale Grauwertanteile der Nutzstrukturen 9, $a_{n,i}$ für Mittelwerte der Grauwertanteile der Nutzstrukturen 9,
$a_{n,min,i}$ für minimale Grauwertanteile der Nutzstrukturen 9, $a_{s,max,i}$ für maximale Grauwertanteile der Störstrukturen 8 und
$a_{s,i}$ für Mittelwerte der Grauwertanteile der Störstrukturen 8 ausgedrückt werden können.

Die unter a) bis e) angegebenen Grauwerte ergeben sich damit zu als Linearkombination der Koeffizienten und der zugehörigen Intensitäten $x_i$:

$$N_{max} = \sum_i (a_{n,max,i} \cdot x_i) \qquad\qquad (1)$$

$$N = \sum_i (a_{n,i} \cdot x_i) \qquad\qquad (2)$$

$$N_{min} = \sum_i (a_{n,min,i} \cdot x_i) \qquad\qquad (3)$$

$$S_{max} = \sum_i (a_{s,max,i} \cdot x_i) \qquad\qquad (4)$$

$$S = \sum_i (a_{s,i} \cdot x_i) \qquad\qquad (5)$$

Werden die Koeffizienten $a_{n,max,i}$, $a_{n,i}$, $a_{n,min,i}$, $a_{s,max,i}$ und $a_{s,i}$ in Zeilenvektoren $A_{n,max}$, $A_n$, $A_{n,min}$, $A_{s,max}$ und $A_s$ mit jeweils i Spalten zusammengefaßt und die Intensitäten $x_i$ in einen Spaltenvektor X mit i Zeilen, so lassen sich die Gl. (1) bis (5) auch als Skalarprodukt von Vektoren schreiben:

$$N_{max} = A_{n,max} \cdot X \qquad\qquad (6)$$

$$N = A_n \cdot X \qquad\qquad (7)$$

$$N_{min} = A_{n,min} \cdot X \qquad\qquad (8)$$

$$S_{max} = A_{s,max} \cdot X \qquad\qquad (9)$$

$$S = A_s \cdot X \qquad\qquad (10)$$

Für die Bestimmung der Koeffizienten werden zunächst die Intensitäten $x_i$ aller Lichtquellen 4 auf einen vorherbestimmten Wert geregelt, zum Beispiel gleich Null und anschließend werden nacheinander die Intensitäten $x_i$ der einzelnen Lichtquellen variiert und wieder auf den vorherbestimmten Wert geregelt. Dabei nimmt die Kamera 6 das Bild des Bauelementes 3 auf und durch die vorherige Zuordnung von Pixeln (bzw. Moxeln) zu Stör- und Nutzstrukturen 9,8 werden zu den eingestellten Intensitäten $x_i$ der jeweiligen Lichtquelle die Grauwertanteile ermittelt. Durch Division der Grauwertanteile durch die eingestellten Intensitäten $x_i$ ergeben sich die Koeffizienten, die in der Bildauswerteeinheit 7 abgespeichert werden.

Damit sind bei beispielsweise sechs Lichtquellen 4 nach der Durchführung der Messung der Grauwertanteile zu den sechs Lichtquellen jeweils fünf Koeffizienten ermittelt worden. Aus diesen dreißig ermittelten Koeffizienten läßt sich nun mit Hilfe einer linearen Optimierung die optimale Beleuchtung automatisch bestimmen.

In einer ersten Ausführungsform werden dafür zunächst Grenzwerte für die Grauwerte oder Differenzen daraus festgelegt. Die Differenz des maximalen Grauwertes $N_{max}$ der Nutzstrukturen 9 und des Mittelwertes N der Grauwerte der Nutzstrukturen 9 soll kleiner sein als ein vorgebener erster Grenzwert GW1.

$$N_{max} - N = (A_{n,max} - A_n) \cdot X \leq GW1 \qquad\qquad (11)$$

Die Differenz des Mittelwertes N der Grauwerte und des minimalen Grauwertes $N_{min}$ der Nutzstrukturen 9 soll kleiner sein als ein vorgegebener zweiter Grenzwert GW2.

$$N - N_{min} = (A_n - A_{n,min}) \cdot X \leq GW2 \qquad\qquad (12)$$

Die Differenz des maximalen Grauwertes $S_{max}$ und des Mittelwertes S der Grauwerte der Störstrukturen 8 soll kleiner sein als ein vorgegebener dritter Grenzwert GW3.

$$S_{max} - S = (A_{s.max} - A_s) \cdot X \leq GW3 \tag{13}$$

Der Mittelwert N der Grauwerte der Nutzstrukturen 9 soll größer sein als ein vorgegebener vierter Grenzwert GW4.

$$N = A_N \cdot X \geq GW4 \tag{14}$$

oder

$$-A_N \cdot X \leq -GW4 \tag{15}$$

Die Intensität soll größer sein als Null, was sich vektoriell nach Einführen eines Hilfsvektors **1** mit Elementen, die die Einheit einer Intensität und den Wert 1 haben, schreiben läßt:

$$\mathbf{1} \cdot X \geq 0 \tag{16}$$

oder

$$-\mathbf{1} \cdot X \leq 0 \tag{17}$$

Durch Einführen eines Vektors B und einer Matrix A lassen sich die Gleichungen (11), (12), (13), (15) und (17) zusammenfassen:

$$B = \begin{pmatrix} GW1 \\ GW2 \\ GW3 \\ -GW4 \\ 0 \end{pmatrix} \tag{18}$$

$$A = \begin{pmatrix} A_{n,max} - A_n \\ A_n - A_{n,min} \\ A_{s,max} - A_s \\ -A_n \\ -1 \end{pmatrix} \tag{19}$$

$$A \cdot X \leq B \tag{20}$$

Anschließend wird überprüft, ob sich die Nutzstrukturen 9 von den Störstrukturen 8 unterscheiden lassen, was der Fall ist, wenn für mindestens eine Lichtquelle i eine große Differenz der Koeffizienten $a_{n,i}$ und $a_{s,i}$ der Mittelwerte der Grauwerte von Nutz- und Störstrukturen 9,8 auftritt:

$$\text{positiver Kontrast:} \quad a_{n,i} \gg a_{s,i} \tag{21}$$

$$\text{negativer Kontrast:} \quad a_{n,i} \ll a_{s,i} \tag{22}$$

Allgemein wird damit ausgedrückt, daß die Grauwertbereiche von Stör- und Nutzstrukturen 9,8 einen hinreichend großen Abstand haben.

Die Optimierungsbedingung lautet dann, daß die Differenz aus den Mittelwerten N und S des Grauwertes der Nutz- und der Störstrukturen 9,8 gleich einem Maximalwert Max werden soll:

$$N - S = Max \tag{23}$$

oder entsprechend (mit einem Minimalwert Min):

$$-(N - S) = Min \tag{24}$$

was sich mit dem Zeilenvektor C

$$C = (A_n - A_s) \tag{25}$$

auch schreiben läßt:

$$-C \cdot X = Min \tag{26}$$

Der Abstand der Grauwertbereiche von Stör- und Nutzstrukturen (8,9) wird somit möglichst groß gewählt.

Wird keine Lichtquelle i gefunden, deren zugeordnete Koeffizienten der Mittelwerte der Grauwerte von Nutz- und Störstrukturen 9,8 sich stark unterscheiden wie in Gl. (21,22), so lassen sich Nutz- und Störstrukturen 9,8 nicht trennen und als Optimierungsbedingung wird die Bedingung verwendet, daß die Differenz der Mittelwerte N und S der Grauwerte von Nutzund Störstrukturen 9,8 einen Minimalwert Min annimmt.

$$N - S = Min \tag{27}$$

oder mit Gl. (25) :

$$C \cdot X = Min \tag{28}$$

Die optimale Beleuchtung wird dann für Nutz- und Störstrukturen 9,8 etwa gleiche Grauwerte liefern, so daß die Lage des Bauelementes 3 anhand der äußeren Form des Bauelementes 3 gegenüber einem Hintergrund erkannt wird. Die Bedingung für den vorgebenenen vierten Grenzwert GW 4 (Gleichung 14 und 15) bezieht sich in diesem Fall auf den Mittelwert S der Grauwerte der Störstrukturen 8.

$$S = A_S \cdot X \geq GW4 \tag{29}$$

oder

$$-A_S \cdot X \leq -GW4 \tag{30}$$

Die Gl. (20) wird in diesem Fall entsprechend angepaßt.

Der Abstand der Grauwertbereiche von Stör- und Nutzstrukturen (8,9) wird somit minimal.

Die Gl.(20) und (26), bzw. Gl.(20) und (28) werden mit Hilfe einer Linearen Optimierungsmethode, beispielsweise dem revidierten Simplex Algorithmus (siehe beispielsweise Bronstein, Semendjajew: Taschenbuch der Mathematik, 24. Aufl., Verlag Harri Deutsch, Thun und Frankfurt/Main S. 711 ff.) mit einem Programm in der Bildauswerteeinheit 7 gelöst und als Resultat ergeben sich die gewünschten Intensitäten $x_i$ der einzelnen Lichtquellen i, die für die optimale Beleuchtung eingestellt werden.

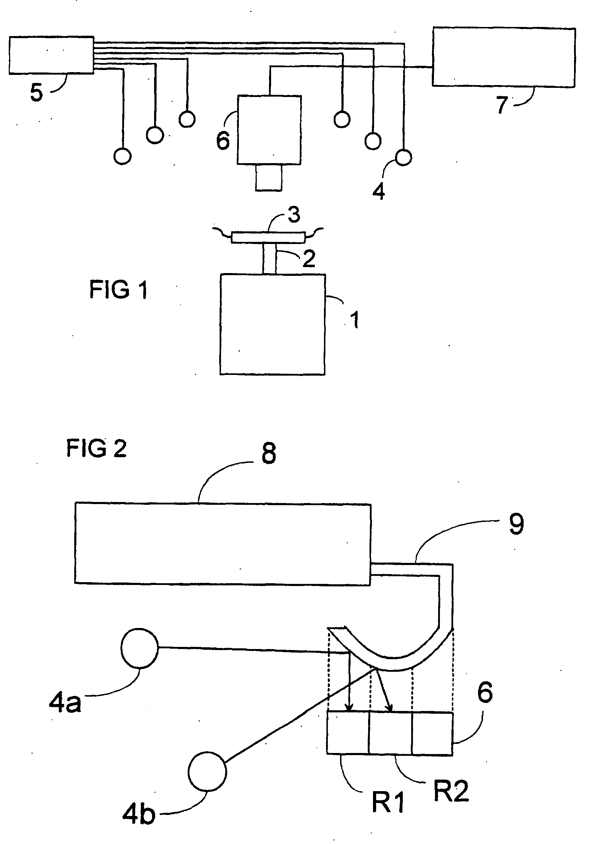

In einem zweiten Ausführungsbeispiel, das - wie in Fig. 2 dargestellt - besonders für Bauelemente 3 mit Anschlüssen 9 mit gewölbter Anschlußfläche geeignet ist, wird das von der Kamera 6 aufgenommene Bild der Anschlüsse als Nutzstruktur 9 in Regionen R1, R2 aufgeteilt, die getrennt untersucht werden. Eine einzelne Lichtquelle 4a bzw. 4b erzeugt keine gleichmäßige Ausleuchtung der Nutzstruktur 9, sondern es entstehen regional helle Flecken, während der Rest der Nutzstruktur 9 dunkel bleibt. Das Pixel oder Moxel mit dem maximalen Grauwert der Struktur ist nicht ortsfest, sondern verändert sich mit verändernder Beleuchtungsrichtung aufgrund unterschiedlicher Lichtquellen 4a, 4b. Aus diesem Grund läßt sich die Differenz zwischen dem maximalen Grauwert $N_{max}$ und dem Mittelwert N nicht als Linearkombination der Intensitätswerte $x_i$ der Lichtquellen 4a, 4b darstellen. Entsprechendes gilt auch für die Differenz zwischen dem Mittelwert N und dem minimalen Grauwert $N_{min}$ sowie für die Differenz zwischen dem maximalen Grauwert $S_{max}$ der Störstruktur und dem Mittelwert S.

Um eine gleichmäßige Darstellung der Nutzstrukturen 9 zu erzielen (entsprechendes gilt für die Störstrukturen 8) werden regionale Koeffizienten $a_{n,R1,i}$ $a_{n,R2,i}$ für den jeweiligen Mittelwert $N_{R1}, N_{R2}$ der Grauwerte der Nutzstrukturen 9 in den jeweiligen Regionen R1, R2 bestimmt. Bei zwei Lichtquellen 4a und zwei Regionen R1, R2 werden insgesamt 4 regionale Koeffizienten $a_{n,R1,i}$ $a_{n,R2,i}$ bestimmt. Die Anzahl der Lichtquellen 4 und der Regionen R1, R2 läßt sich je nach Problemstellung. variieren. Die Mittelwerte $N_{R1}, N_{R2}$ der Grauwerte in den Regionen R1, R2 ergeben sich analog als Linearkombination der regionalen Koeffizienten $a_{n,R1,i}$ $a_{n,R2,i}$ und der Intensitäten $x_i$ der Lichtquellen 4a , 4b. Als Grenzbedingung ist zu beachten, daß die Mittelwerte $N_{R1}, N_{R2}$ der Grauwerte der Regionen R1, R2 nicht größer als ein fünfter Grenzwert GW5 sind, damit die Signalbegrenzung der Kamera 6 nicht überschritten wird.

$$N_{R1}, N_{R2} \leq GW5 \hspace{4cm} (31)$$

Bei der Ermittlung der Koeffizienten $a_{n,i}$ für die Mittelwerte $N_{R1}, N_{R2}$ der Grauwerte der Nutzstruktur 9 wird davon ausgegangen, daß alle Lichtquellen 4a, 4b zur Beleuchtung benutzt werden. Entsprechend ergibt sich der Koeffizient $a_{n,i}$ für die Mittelwerte $N_{R1}, N_{R2}$ der Grauwerte der Nutzstruktur als arithmetisches Mittel der regionalen Koeffizienten $a_{n,R1,i}$ $a_{n,R2,i}$.

Die Bestimmung der optimalen Beleuchtung erfolgt dann analog zum geschilderten ersten Ausführungsbeispiel.

**Patentansprüche**

1. Verfahren zur automatischen Intensitätseinstellung einer Beleuchtung einer Einrichtung zur Lageerkennung und/oder Qualitätskontrolle in Bestückautomaten für Bauelemente (3), wobei die Einrichtung eine Beleuchtungseinrichtung aus mindestens zwei Lichtquellen (4) mit zugeordneten, regelbaren Intensitätssteuereinrichtungen (5) sowie eine zugeordnete Kamera (6) mit nachgeschalteter Bildauswerteeinheit (7) umfaßt, welche zumindest bereichsweise eine in Bildpunkte (Pixel) gerasterte Abbildung des Bauelementes (3) in Form von Grauwerten aufnimmt,

   **dadurch gekennzeichnet,**

   **daß** die Abbildung des Bauelementes (3) in für die Lageerkennung und/oder.Qualitätskontrolle störende Strukturen (Störstrukturen) (8) und nützliche Strukturen (Nutzstrukturen) (9) des Bauelementes (3) aufgeteilt wird und die Zuordnung der Bildpunkte zu Stör- und Nutzstrukturen (8,9) in der Bildauswerteeinheit (7) abgespeichert wird,

   **daß** das Bauelement (3) in der Einrichtung zur Lageerkennung und/oder Qualitätskontrolle nacheinander durch jeweils eine der mindestens zwei Lichtquellen (4) mit variierender Intensität beleuchtet wird,

   **daß** die Grauwerte der mit der Kamera (6) aufgenommenen Abbildung als Grauwertanteile in der Bildauswerteeinheit (7) gespeichert und den Stör- und Nutzstrukturen (8,9) zugeordnet werden und damit die Abhängigkeit von Grauwertbereichen der Stör- und Nutzstrukturen (8,9) von der Intensität ($x_i$) der einzelnen Lichtquellen (4) ermittelt wird,

   **daß** in der Bildauswerteeinheit (7) die gespeicherten Grauwertanteile aller Lichtquellen (4) geordnet nach Nutz- und Störstrukturen (9,8) aufsummiert werden und die ermittelten Grauwertsummen der Stör- und Nutzstrukturen (8,9) untereinander verglichen werden,

**daß** mit Hilfe einer linearen Optimierung die optimale Beleuchtung automatisch so bestimmt wird,

- **daß** für den Fall der Existenz mindestens einer Lichtquelle (4), deren Beleuchtung zu einer Differenz zwischen den Mittelwerten der Grauwerte von Stör- und Nutzstrukturen (8,9) führt, wobei der Betrag der Differenz einen vorbestimmten Wert überschreitet, unter Berücksichtigung der Beleuchtung von allen Lichtquellen (4) eine maximale Differenz zwischen den Mittelwerten der Grauwerte von Störund Nutzstrukturen (8,9) angestrebt wird
- und falls keine Lichtquelle (4) existiert, deren Beleuchtung zu einer Differenz zwischen den Mittelwerten der Graüwerte von Stör- und Nutzstrukturen (8,9) führt, wobei der Betrag der Differenz einen vorbestimmten Wert überschreitet, unter Berücksichtigung der Beleuchtung von allen Lichtquellen (4) eine minimale Differenz zwischen den Mittelwerten der Grauwerte von Stör- und Nutzstrukturen (8, 9) angestrebt wird.

2. Verfahren zur automatischen Intensitätseinstellung einer Beleuchtung nach Anspruch 1,
   **dadurch gekennzeichnet,**
   **daß** die gemessenen Grauwertanteile pixelweise oder über mehrere Pixel gemittelt der Lichtquelle (4) und der Intensität der Lichtquelle ($x_i$) zugeordnet und in der Bildauswerteeinheit (7) gespeichert werden.

3. Verfahren zur automatischen Intensitätseinstellung einer Beleuchtung nach einem der Ansprüche 1 oder 2,
   **dadurch gekennzeichnet,**
   **daß** in der Bildauswerteeinheit (7) zu jeder Lichtquelle (4) und jeder eingestellten Intensität ($x_i$) der minimale Grauwertanteil der Nutzstrukturen (9) ermittelt und durch Division durch die eingestellte Intensität ($x_i$) ein Koeffizient ($a_{n,min,i}$) des minimalen Grauwertanteils der Nutzstrukturen (9) ermittelt und abgespeichert wird, so daß ein minimaler Grauwert ($N_{min}$) der Nutzstrukturen (9) durch eine Linearkombination dieser Koeffizienten ($a_{n,min,i}$) und der eingestellten Intensität ($x_i$) aller Lichtquellen (4) ermittelbar ist.

4. Verfahren zur automatischen Intensitätseinstellung einer Beleuchtung nach einem der Ansprüche 1 bis 3,
   **dadurch gekennzeichnet,**
   **daß** in der Bildauswerteeinheit (7) zu jeder Lichtquelle (4) und jeder eingestellten Intensität ($x_i$) der Mittelwert der Grauwertanteile der Nutzstrukturen (9) ermittelt und durch Division durch die eingestellte Intensität ($x_i$) ein Koeffizient ($a_{n,i}$) des Mittelwertes der Grauwertanteile der Nutzstrukturen (9) ermittelt und abgespeichert wird, so daß ein Mittelwert der Grauwerte (N) der Nutzstrukturen (9) durch eine Linearkombination dieser Koeffizienten ($a_{n,i}$) und der eingestellten Intensität ($x_i$) aller Lichtquellen (4) ermittelbar ist.

5. Verfahren zur automatischen Intensitätseinstellung einer Beleuchtung nach einem der Ansprüche 1 bis 3,
   **dadurch gekennzeichnet,**
   **daß** die Nutzstrukturen (9) in mindestens zwei Regionen (R1,R2) unterteilt werden,
   **daß** in der Bildauswerteeinheit (7) zu jeder Lichtquelle (4) und jeder eingestellten Intensität ($x_i$) der Mittelwert der Grauwertanteile der jeweiligen Region (R1, R2) der Nutzstruktur (9) ermittelt und durch Division durch die eingestellte Intensität ($x_i$) ein regionaler Koeffizient ($a_{n,R1,i}$ $a_{n,R2,i}$) des Mittelwertes der Grauwertanteile der Region (R1,R2) der Nutzstrukturen (9) ermittelt und abgespeichert wird, so daß ein Mittelwert ($N_{R1}$, $N_{R2}$) der Grauwerte der Region (R1,R2) der Nutzstrukturen (9) durch eine Linearkombination dieser regionalen Koeffizienten ($a_{n,R1,i}$ $a_{n,R2,i}$) und der eingestellten Intensität ($x_i$) aller Lichtquellen (4) ermittelbar ist.

6. Verfahren zur automatischen Intensitätseinstellung einer Beleuchtung nach Anspruch 4,
   **dadurch gekennzeichnet,**
   **daß** ein Mittelwert (N) der Grauwerte der Nutzstrukturen (9) durch eine Linearkombination aus aus den regionalen Koeffizienten ($a_{n,R1,i}$ $a_{n,R2,i}$) ermittelten Koeffizienten ($a_{n,i}$) des Mittelwerts der Grauwerte der Nutzstrukturen (9) und der eingestellten Intensität ($x_i$) aller Lichtquellen (4) ermittelt wird.

7. Verfahren zur automatischen Intensitätseinstellung einer Beleuchtung nach Anspruch 6,
   **dadurch gekennzeichnet,**
   **daß** der Koeffizient ($a_{n,i}$) des Mittelwerts der Grauwerte der Nutzstrukturen (9) durch Mittelwertbildung aus den regionalen Koeffizienten ($a_{n,R1,i}$ $a_{n,R2,i}$) ermittelt wird.

8. Verfahren zur automatischen Intensitätseinstellung einer Beleuchtung nach einem der Ansprüche 1 bis 7,
   **dadurch gekennzeichnet,**
   **daß** in der Bildauswerteeinheit (7) zu jeder Lichtquelle (4) und jeder eingestellten Intensität ($x_i$) der maximale Grauwertanteil der Nutzstrukturen (9) ermittelt und durch Division durch die eingestellte Intensität ($x_i$) ein Koeffi-

zient ($a_{n,max,i}$) des maximalen Grauwertanteils der Nutzstrukturen (9) ermittelt und abgespeichert wird, so daß ein maximaler Grauwert ($N_{max}$) der Nutzstrukturen (9) durch eine Linearkombination dieser Koeffizienten ($a_{n,max,i}$) und der eingestellten Intensität ($x_i$) aller Lichtquellen (4) ermittelbar ist.

9. Verfahren zur automatischen Intensitätseinstellung einer Beleuchtung nach einem der Ansprüche 1 bis 8,
**dadurch gekennzeichnet,**
**daß** in der Bildauswerteeinheit (7) zu jeder Lichtquelle (4) und jeder eingestellten Intensität ($x_i$) der maximale Grauwertanteil der Störstrukturen (8) ermittelt und durch Division durch die eingestellte Intensität ($x_i$) ein Koeffizient ($a_{s,max,i}$) des maximalen Grauwertanteils der Störstrukturen (8) ermittelt und abgespeichert wird, so daß ein maximaler Grauwert ($S_{max}$) der Störstrukturen (8) durch eine Linearkombination dieser Koeffizienten ($a_{s,max,i}$) und der eingestellten Intensität ($x_i$) aller Lichtquellen (4) ermittelbar ist.

10. Verfahren zur automatischen Intensitätseinstellung einer Beleuchtung nach einem der Ansprüche 1 bis 9,
**dadurch gekennzeichnet,**
**daß** in der Bildauswerteeinheit (7) zu jeder Lichtquelle (4) und jeder eingestellten Intensität ($x_i$) der Mittelwert der Grauwertanteile der Störstrukturen (8) ermittelt und durch Division durch die eingestellte Intensität ($x_i$) ein Koeffizient ($a_{s,i}$) des Mittelwertes der maximalen Grauwertanteile der Störstrukturen (9) ermittelt und abgespeichert wird, so daß ein Mittelwert der Grauwerte (S) der Störstrukturen (8) durch eine Linearkombination dieser Koeffizienten ($a_{s,i}$) und der eingestellten Intensität ($x_i$) aller Lichtquellen (4) ermittelbar ist.

11. Verfahren zur automatischen Intensitätseinstellung einer Beleuchtung nach Anspruch 10,
**dadurch gekennzeichnet,**
**daß** die Koeffizienten ($a_{n,i}$ , $a_{s,i}$) der Mittelwerte der Grauwertanteile der Nutz- und der Störstrukturen (8,9)bezüglich einzelner Lichtquellen (4) miteinander verglichen werden,
**daß**, falls eine Lichtquelle (4) existiert, deren zugeordnete Koeffizienten ($a_{n,i}$ , $a_{s,i}$) der Mittelwerte der Grauwerte von Nutz- und Störstrukturen (8,9) sich stark unterscheiden, als Optimierungsbedingung eine möglichst große Differenz der Mittelwerte (N-S) der Grauwerte von Nutz- und Störstrukturen (8,9) gewählt wird,
und ansonsten als Optimierungsbedingung eine möglichst kleine die Differenz der Mittelwerte (N-S) der Grauwerte von Nutzund Störstrukturen (8,9) gewählt wird.

12. Verfahren zur automatischen Intensitätseinstellung einer Beleuchtung nach einem der Ansprüche 1 bis 11,
**dadurch gekennzeichnet,**
**daß** Grenzwerte (GW1, GW2, GW3, GW4, GW5) für die Grauwerte oder für Differenzen oder Quotienten von Grauwerten vorgegeben werden.

13. Verfahren zur automatischen Intensitätseinstellung einer Beleuchtung nach Anspruch 12,
**dadurch gekennzeichnet,**
**daß** mit den Grenzwerten (GW1, GW2, GW3, GW4, GW5) mindestens eine der Grenzbedingungen
für die Differenz aus dem maximalen Grauwert und dem Mittelwert der Grauwerte der Nutzstrukturen ($N_{max}$-N $\leq$ GW1),
für die Differenz aus dem Mittelwert der Grauwerte und dem minimalen Grauwert der Nutzstrukturen (N-$N_{min}$ $\leq$ GW2),
für die Differenz aus dem maximalen Grauwert und dem Mittelwert der Grauwerte der Störstrukturen ($S_{max}$-S $\leq$ GW3),
für den Mittelwert der Grauwerte der Nutzstrukturen (N $\geq$ GW4) und für die Intensitäten ($x_i$)
vorgegeben wird.

14. Verfahren zur automatischen Intensitätseinstellung einer Beleuchtung nach Anspruch 12,
**dadurch gekennzeichnet,**
**daß** mit den Grenzwerten (GW1, GW2, GW3, GW4, GW5) mindestens eine der Grenzbedingungen
für die Mittelwerte ($N_{R1}$, $N_{R2}$) der Grauwerte der Regionen der Nutzstrukturen ($N_{R1}$,$N_{R2}$ $\leq$ GW5),
für den Mittelwert der Grauwerte der Störstrukturen und für die Intensitäten ($x_i$)
vorgegeben wird.

15. Verfahren zur automatischen Intensitätseinstellung einer Beleuchtung nach einem der Ansprüche 13 oder 14,
**dadurch gekennzeichnet,**
**daß** aus den Grenzbedingungen und der Optimierungsbedingung ein lineares Ungleichungssystem gebildet wird,
und **daß** das lineare Ungleichungssystem mit Hilfe einer Linearen Optimierung in der Bildauswerteeinheit (7) gelöst wird.

16. Verfahren zur automatischen Intensitätseinstellung einer Beleuchtung nach Anspruch 15,
**dadurch gekennzeichnet,**
**daß** als Verfahren für die Lineare Optimierung der revidierte Simplex Algorithmus verwendet wird.


**Claims**

1. Method for automatically setting the intensity of an illumination of a device for detecting a position and/or for quality control in printed-circuit-board assembly machines for components (3), the device comprising an illuminator composed of at least two light sources (4) with assigned, controllable intensity control devices (5), and comprising an assigned camera (6) with a downstream image evaluation unit (7) which takes an image, rastorized in pixels, of the component (3) in the form of grey-scale values, **characterized in that** the image of the component (3) is divided into structures (interference structures) (8) causing interference in detecting a position and/or for quality control, and useful structures (9) of the component (3), and the assignment of the pixels to interference and useful structures (8, 9) is stored in the image evaluation unit (7), **in that** the component (3) is sequentially illuminated with varying intensity in the device for detecting a position and/or for quality control by respectively one of the at least two light sources (4), **in that** the grey-scale values of the image taken by the camera (6) are stored as grey-scale value fractions in the image evaluation unit (7) and assigned to the interference and useful structures (8, 9), and in this way the dependence of grey-scale ranges of the interference and useful structures (8, 9) on the intensity ($x_i$) of the individual light sources (4) is determined, **in that** the stored grey-scale fractions of all the light sources (4) are totalled in the image evaluation unit (7) in a fashion ordered by useful and interference structures (9, 8), and the determined grey-scale sums of the interference and useful structures (8, 9) are intercompared, and **in that** a linear optimization is used to determine the optimum illumination automatically such that for the case of the existence of at least one light source (4) whose illumination leads to a difference between the mean values of the grey-scale values of interference and useful structures (8, 9), the absolute value of the difference exceeding a predetermined value, aim is a maximum difference between the mean values of the grey-scale values of interference and useful structures (8, 9), account being taken of the illumination of all the light sources (4), and if there is no light source (4) whose illumination leads to a difference between the mean values of the grey-scale values of interference and useful structures (8, 9), the absolute value of the difference exceeding a predetermined value, the aim is a minimum difference between the mean values of the grey-scale values of interference and useful structures (8, 9), account being taken of the illumination of all light sources (4).

2. Method for automatically setting the intensity of an illumination according to Claim 1, **characterized in that** the measured grey-scale fractions are assigned to the light source (4), excelled by pixel or averaged over a plurality of pixels, and to the intensity ($x_i$) of the light source, and are stored in the image evaluation unit (7).

3. Method for automatically setting the intensity of an illumination according to one of Claims 1 or 2, **characterized in that** the minimum grey-scale fraction of the useful structures (9) is determined in the image evaluation unit (7) in relation to each light source (4) and to each set intensity ($x_i$), and a coefficient ($a_n,min,i$) of the minimum grey-scale fraction of the useful structures (9) is determined by division by the set intensity ($x_i$) and stored such that a minimum grey-scale value ($N_{min}$) of the useful structures (9) can be determined by a linear combination of these coefficients ($a_n,min,i$) and the set intensity ($x_i$) of all the light sources (4).

4. Method for automatically setting the intensity of an illumination according to one of Claims 1 to 3, **characterized in that** the mean value of the grey-scale fractions of the useful structures (9) is determined in the image evaluation unit (7) in relation to each light source (4) and each set intensity ($x_i$), and a coefficient ($a_{n,i}$) of the mean value of the grey-scale fractions of the useful structures (9) is determined by division by the set intensity ($x_i$) and stored such that a mean value of the grey-scale values (N) of the useful structures (9) and be determined by a linear combination of these coefficients ($a_{n,i}$) and the set intensity ($x_i$) of all the light sources (4).

5. Method for automatically setting the intensity of an illumination according to one of Claims 1 to 3, **characterized in that** the useful structures (9) are subdivided into at least two regions (R1, R2), **in that** the mean value of the grey-scale fractions of the respective region (R1, R2) of the useful structure (9) is determined in the image evaluation unit (7) in relation to each light source (4) and each set intensity ($x_i$), and a regional coefficient ($a_{n,R1,i}$ $a_{n,R2,i}$) of the mean value of the grey-scale fractions of the region (R1, R2) of the useful structures (9) is determined by dividing by the set intensity ($x_i$) and stored such that a mean value ($N_{R1}$, $N_{R2}$) of the grey-scale values of the region (R1, R2) of the useful structures (9) can be determined by a linear combination of these regional coefficients ($a_{n,R1,i}$ $a_{n,R2,i}$) and the set intensity ($x_i$) of all the light sources (4).

6. Method for automatically setting the intensity of an illumination according to Claim 4, **characterized in that** a mean value (N) of the grey-scale values of the useful structures (9) is determined by a linear combination of coefficients ($a_{n,i}$), determined from the regional coefficients ($a_{n,R1,i}$ $a_{n,R2,i}$) of the mean value of the grey-scale values of the useful structures (9) and the set intensity ($x_i$) of all the light sources (4).

7. Method for automatically setting the intensity of an illumination according to Claim 6, **characterized in that** the coefficient ($a_{n,i}$) of the mean value of the grey-scale values of the useful structures (9) is determined by averaging the regional coefficients ($a_{n,R1,i}$ $a_{n,R2,i}$).

8. Method for automatically setting the intensity of an illumination according to one of Claims 1 to 7, **characterized in that** the maximum grey-scale fraction of the useful structures (9) is determined in the image evaluation unit (7) in relation to each light source (4) and to each set intensity ($x_i$), and a coefficient ($a_{n,max,i}$) of the maximum grey-scale fraction of the useful structures (9) is determined by division by the set intensity ($x_i$) and stored such that a maximum grey-scale value ($N_{max}$) of the useful structures (9) can be determined by a linear combination of these coefficients ($a_{n,max,i}$) and the set intensity ($x_i$) of all the light sources (4).

9. Method for automatically setting intensity of an illumination according to one of Claims 1 to 8, **characterized in that** the maximum grey-scale fraction of the interference structures (8) is determined in the image evaluation unit (7) in relation to each light source (4) and each set intensity ($x_i$), and a coefficient ($a_{s,max,i}$) of the maximum grey-scale fraction of the interference structures (8) is determined by division by the set intensity ($x_i$) and stored such that a maximum grey-scale value ($S_{max}$) of the interference structures (8) can be determined by a linear combination of these coefficients ($a_{s,max,i}$) and the set intensity ($x_i$) of all the light sources (4).

10. Method for automatically setting the intensity of an illumination according to one of Claims 1 to 9, **characterized in that** the mean value of the grey-scale fractions of the interference structures (8) is determined in the image evaluation unit (7) in relation to each light source (4) and each set intensity ($x_i$), and a coefficient ($a_{s,i}$) of the mean value of the grey-scale fractions of the interference structures (8) is determined by division by the set intensity ($x_i$) and stored such that a mean value of the grey-scale values (S) of the interference structures (8) can be determined by a linear combination of these coefficients ($a_{s,i}$) and the set intensity ($x_i$) of all the light sources (4).

11. Method for automatically setting the intensity of an illumination according to Claim 10, **characterized in that** the coefficients ($a_{n,i}$, $a_{s,i}$) of the mean values of the grey-scale fractions of the useful and the interference structures (8, 9) are intercompared with reference to individual light sources (4), and **in that** if there is a light source (4) whose assigned coefficients ($a_{n,i}$, $a_{s,i}$) of the mean values of the grey-scale values of useful and interference structures (8, 9) differ strongly from one another, as large as possible a difference between the mean values (N-S) of the grey-scale values of useful and interference structures (8, 9) is selected as optimization condition, and otherwise as small as possible a difference between the mean values (N-S) of the grey-scale values of useful and interference structures (8, 9) is selected as optimization condition.

12. Method for automatically setting the intensity of an illumination according to one of Claims 1 to 11, **characterized in that** limiting values (GW1, GW2, GW3, GW4, GW5) are prescribed for the grey-scale values or for the differences or quotients of grey-scale values.

13. Method for automatically setting the intensity of an illumination according to Claim 12, **characterized in that** the limiting values (GW1, GW2, GW3, GW4, GW5) prescribe at least one of the boundary conditions for the difference between the maximum grey-scale value and the mean value of the grey-scale values of the useful structures ($N_{max}$-N $\leq$ GW1), for the difference between the mean value of the grey-scale values and the minimum grey-scale value of the useful structures (N-$N_{min}$ $\leq$ GW2), for the difference between the maximum grey-scale value and the mean value of the grey-scale values of the interference structures ($S_{max}$-S $\leq$ GW3), for the mean value of the grey-scale values of the useful structures (N $\geq$ GW4), and for the intensity ($x_i$).

14. Method for automatically setting the intensity of an illumination according to Claim 12, **characterized in that** the limiting values (GW1, GW2, GW3, GW4, GW5) prescribe at least one of the boundary conditions for the mean values ($N_{R1}$, $N_{R2}$) of the grey-scale values of the regions of the useful structures ($N_{R1}$,$N_{R2}$ $\leq$ GW5), for the mean value of the grey-scale values of the interference structures, and for the intensities ($x_i$).

**15.** Method for automatically setting the intensity of an illumination according to one of Claims 13 or 14, **characterized in that** a system of linear inequalities is formed from the boundary conditions and the optimization condition, and **in that** the system of linear inequalities is solved with the aid of a linear optimization in the image evaluation unit (7).

**16.** Method for automatically setting the intensity of an illumination according to Claim 15, **characterized in that** the revised simplex algorithm is used as method for the linear optimization.

**Revendications**

**1.** Procédé pour régler automatiquement l'intensité d'un éclairage destiné à des unités servant à détecter une position et/ou à effectuer un contrôle de qualité dans des automates de mise en place de composants (3), l'unité comprenant un système d'éclairage constitué d'au moins deux sources lumineuses (4) avec des dispositifs de réglage de l'intensité règlables (5) affectés à celle-ci, ainsi qu'une caméra (6) affectée à celle-ci avec une unité d'évaluation d'images (7) installée en aval, qui enregistre une représentation par trame pixelisée, au moins de certaines régions, du composant (3) sous forme de valeurs de gris, **caractérisé en ce que**, la représentation du composant (3) est divisée en structures parasites (8) pour la détection d'une position et/ou le contrôle de qualité et en structures utiles (9) du composant (3) et **en ce que** l'attribution des pixels aux structures parasites et utiles (8, 9) est mémorisée dans l'unité d'évaluation d'images (7), **en ce que** le composant (3) dans l'unité servant à la détection d'une position et/ou à effectuer le contrôle de qualité est éclairé successivement par respectivement une des au moins deux sources lumineuses (4) avec une intensité variable, **en ce que** les valeurs de gris de la représentation enregistrée par la caméra (6) sont mémorisées comme pourcentages des valeurs de gris dans l'unité d'évaluation d'images (7) et attribuées aux structures parasites et utiles (8, 9) et afin que la dépendance des zones de valeurs de gris des structures parasites et utiles (8, 9) de l'intensité ($x_i$) des sources lumineuses individuelles (4) soit déterminée, **en ce que** les pourcentages mémorisés de valeurs de gris de toutes les sources lumineuses (4) classés par structures utiles et parasites (9,8) sont totalisées dans l'unité d'évaluation d'images (7) et **en ce que** les totaux des valeurs de gris des structures parasites et utiles (8, 9) sont comparés les uns avec les autres, **en ce que** l'éclairage optimal est déterminé automatiquement à l'aide d'une optimisation linéaire,

- de sorte qu'en cas d'existence d'au moins une source lumineuse (4), dont l'éclairage entraîne une différence entre les valeurs moyennes des valeurs de gris des structures parasites et utiles (8, 9), le montant de la différence dépassant une valeur prédéterminée, compte tenu de l'éclairage de toutes les sources lumineuses (4) une différence maximale entre les valeurs moyennes des valeurs de gris des structures parasites et utiles (8, 9) est recherchée et

- en cas d'absence de source lumineuse (4), dont l'éclairage entraîne une différence entre les valeurs moyennes des valeurs de gris des structures parasites et utiles (8, 9), le montant de la différence dépassant une valeur prédéterminée, compte tenu de l'éclairage de toutes les sources lumineuses (4) une différence minimale entre les valeurs moyennes des valeurs de gris des structures parasites et utiles (8, 9) est recherchée .

**2.** Procédé de réglage automatique de l'intensité d'un éclairage selon la revendication 1, **caractérisé en ce que** les pourcentages de valeurs de gris mesurés sont attribués par pixels ou par moyenne de plusieurs pixels à la source lumineuse (4) et à l'intensité de la source lumineuse ($x_i$) et mémorisés dans l'unité d'évaluation d'images (7).

**3.** Procédé de réglage automatique de l'intensité d'un éclairage selon l'une des revendications 1 ou 2, **caractérisé en ce que** le pourcentage minimal de valeurs de gris des structures utiles (9) est déterminé dans l'unité d'évaluation d'images (7) pour chaque source lumineuse (4) et pour chaque intensité réglée ($x_i$) et un coefficient ($a_{n,min,i}$) du pourcentage de valeurs de gris minimal des structures utiles (9) est déterminé par division par l'intensité réglée ($x_i$) et mémorisée, de sorte qu'une valeur de gris minimale ($N_{min}$) des structures utiles (9) peut être déterminée par une combinaison linéaire de ces coefficients ($a_{n,min,i}$), ainsi que de l'intensité réglée ($x_i$) de toutes les sources lumineuses (4).

**4.** Procédé de réglage automatique de l'intensité d'un éclairage selon l'une des revendications 1 à 3, **caractérisé en ce que**, la valeur moyenne des pourcentages de valeurs de gris des structures utiles (9) est déterminée dans l'unité d'évaluation d'images (7) pour chaque source lumineuse (4) et pour chaque intensité réglée ($x_i$) et un coefficient ($a_{n,i}$) de la valeur moyenne des pourcentages de valeurs de gris des structures utiles (9) est déterminé par division par l'intensité réglée ($x_i$) de sorte qu'une valeur moyenne des valeurs de gris (N) des structures utiles (9) peut être déterminée par une combinaison linéaire de ces coefficients ($a_{n,i}$), ainsi que de l'intensité réglée ($x_i$) de toutes les sources lumineuses (4).

**5.** Procédé de réglage automatique de l'intensité d'un éclairage selon l'une des revendications 1 à 3, **caractérisé en ce que**, les structures utiles (9) sont divisées en au moins deux régions (R1, R2), **en ce que** la valeur moyenne des pourcentages de valeurs de gris de chaque région (R1, R2) de la structure utile (9) est déterminée dans l'unité d'évaluation d'images (7) pour chaque source lumineuse (4) et pour chaque intensité réglée ($x$;) et un coefficient régional ($a_{n,R1,i}$ $a_{n,R2,i}$) de la valeur moyenne des pourcentages de valeurs de gris de la région (R1, R2) des structures utiles (9) est déterminé par division par l'intensité réglée ($x_i$) et méorisée de sorte qu'une valeur moyenne ($N_{R1}$, $N_{R2}$) des valeurs de gris de la région (R1, R2) des structures utiles (9) peut être déterminée par une combinaison linéaire de ces coefficients régionaux ($a_{n,R1,i}$ $a_{n,R2,i}$) ainsi que de l'intensité réglée ($x_i$) de toutes les sources lumineuses (4).

**6.** Procédé de réglage automatique de l'intensité d'un éclairage selon la revendication 4, **caractérisé en ce qu'**une valeur moyenne (N) des valeurs de gris des structures utiles (9) est déterminée par une combinaison linéaire des coefficients ($a_{n,i}$) de la valeur moyenne des valeurs de gris des structures utiles (9) déterminés à partir des coefficients régionaux ($a_{n,R1,i}$ $a_{n,R2,i}$) ainsi que de l'intensité réglée ($x_i$) de toutes les sources lumineuses (4).

**7.** Procédé de réglage automatique de l'intensité d'un éclairage selon la revendication 6, **caractérisé en ce que** le coefficient ($a_{n,i}$) de la valeur moyenne des valeurs de gris des structures utiles (9) est déterminé par la formation de la valeur moyenne à partir des coefficients régionaux ($a_{n,R1,i}$ $a_n$, $R_{2,i}$).

**8.** Procédé de réglage automatique de l'intensité d'un éclairage selon l'une des revendications 1 à 7, **caractérisé en ce que** le pourcentage de valeurs de gris maximal des structures utiles (9) est déterminé dans l'unité d'évaluation d'images (7) pour chaque source lumineuse (4) et pour chaque intensité réglée ($x_i$) et un coefficient ($a_{n,max,i}$) du pourcentage maximal de valeurs de gris des structures utiles (9) est déterminé par division par l'intensité réglée ($x_i$) et mémorisé, de sorte qu'une valeur de gris maximale ($N_{max}$) des structures utiles (9) peut être déterminée par une combinaison linéaire de ces coefficients ($a_{n,max,i}$) ainsi que de l'intensité réglée ($x_i$) de toutes les sources lumineuses (4).

**9.** Procédé de réglage automatique de l'intensité d'un éclairage selon l'une des revendications 1 à 8, **caractérisé en ce que** le pourcentage de valeurs de gris maximal des structures parasites (8) est déterminé dans l'unité d'évaluation d'images (7) pour chaque source lumineuse (4) et pour chaque intensité réglée ($x_i$) et un coefficient ($a_{s,max,i}$) du pourcentage maximal de valeurs de gris des structures parasites (8) est déterminé par division par l'intensité réglée ($x_i$) et mémorisé, de sorte qu'une valeur de gris maximale ($S_{max}$) des structures parasites (8) peut être déterminée par une combinaison linéaire de ces coefficients ($a_{s,max,i}$) ainsi que de l'intensité réglée ($x_i$) de toutes les sources lumineuses (4).

**10.** Procédé de réglage automatique de l'intensité d'un éclairage selon l'une des revendications 1 à 9, **caractérisé en ce que** la valeur moyenne des pourcentages de valeurs de gris des structures parasites (8) est déterminée dans l'unité d'évaluation d'images (7) pour chaque source lumineuse (4) et pour chaque inténsité réglée ($x_i$) et un coefficient ($a_{s,i}$) de la valeur moyenne des pourcentages maxima des valeurs de gris des structures parasites (9) est déterminé par division par l'intensité réglée ($x_i$), et mémorisé, de sorte qu'une valeur moyenne des valeurs de gris (S) des structures parasites (8) peut être déterminée par une combinaison linéaire de ces coefficients ($a_{s,i}$) ainsi que de l'intensité réglée ($x_i$) de toutes les sources lumineuses (4).

**11.** Procédé de réglage automatique de l'intensité d'un éclairage selon la revendication 10, **caractérisé en ce que** les coefficients ($a_{n,i}$ $a_{s,}$i) des valeurs moyennes des pourcentages de valeurs de gris des structures utiles et parasites (8, 9) sont comparés les unes avec les autres en rapport avec des sources lumineuses individuelles (4), **en ce que** si une source lumineuse (4) existe, dont les coefficients attribués ($a_{n,i}$, $a_{s,i}$) se différencient fortement des valeurs moyennes des valeurs de gris des structures utiles et parasites (8, 9), une différence la plus grande possible des valeurs moyennes (N-S) des valeurs de gris des structures utiles et parasites (8, 9) est choisie comme condition d'optimisation, et **en ce que** sinon une différence la plus petite possible des valeurs moyennes (N-S) des valeurs de gris des valeurs utiles et parasites (8, 9) est choisie comme condition d'optimisation.

**12.** Procédé pour le réglage automatique de l'intensité d'un éclairage selon l'une des revendications 1 à 11, **caractérisé en ce que** des valeurs limites (GW1, GW2, GW3, GW4, GW5) sont prescrites pour les valeurs de gris ou pour des différences ou des quotients de valeurs de gris.

**13.** Procédé pour le réglage automatique de l'intensité d'un éclairage selon la revendication 12, **caractérisé en ce que** avec les valeurs limites (GW1, GW2, GW3, GW4, GW5) au moins une des conditions limites est prescrite pour la différence entre la valeur de gris maximale et la valeur moyenne des valeurs de gris des structures utiles ($N_{max}$-N ≤ GW1), pour la différence entre la valeur moyenne des valeurs de gris et la valeur de gris minimale des structures utiles (N-$N_{min}$ ≤ GW2), pour la différence entre la valeur de gris maximale et la valeur moyenne des valeurs de gris des structures parasites ($S_{max}$-S ≤ GW3), pour la valeur moyenne des valeurs de gris des structures utiles (N ≥ GW4) et pour les intensités ($x_i$).

14. Procédé de réglage automatique de l'intensité d'un éclairage selon la revendication 12, **caractérisé en ce que** avec les valeurs limites (GW1, GW2, GW3, GW4, GW5), au moins une des conditions limites est prescrite pour les valeurs moyennes ($N_{R1}$, $N_{R2}$) des valeurs de gris des régions des structures utiles ($N_{R1}$,$N_{R2}$ ≤ GW5), pour la valeur moyenne des valeurs de gris des structures parasites et pour les intensités ($x_i$).

15. Procédé de réglage automatique de l'intensité d'un éclairage selon l'une des revendications 13 ou 14, **caractérisé en ce qu'**un système d'inéquation linéaire est formé à partir des conditions limites et de la condition d'optimisation, et **en ce que** le système d'inéquation linéaire est résolu à l'aide d'une optimisation linéaire dans l'unité d'évaluation d'images (7).

16. Procédé de réglage automatique de l'intensité d'un éclairage selon la revendication 15, **caractérisé en ce que** l'algorithme simple révisé est utilisé comme procédé pour l'optimisation linéaire.

FIG 1

5

6

4

3

2

1

7

FIG 2

8

9

4a

4b

6

R1    R2